# EUROPEAN PATENT SPECIFICATION

(11) **EP 0 468 422 B1**
(45) Date of publication and mention of the grant of the patent: **17.09.1997**
(21) Application number: 91112271.1
(22) Date of filing: 22.07.1991
(51) Int. Cl.: G11C 11/412, H01L 27/11

(54) **Semiconductor memory**
Halbleiterspeicher
Mémoire à semi-conducteurs

(30) Priority: 25.07.1990 JP 196822/90
(43) Date of publication of application: 29.01.1992
(73) Proprietor: SONY CORPORATION, Tokyo (JP)
(72) Inventor: Kayama, Shigeki, c/o Sony Corporation, Tokyo (JP)
(74) Representative: Müller, Frithjof E., Dipl.-Ing.

(56) References cited:
- US-A- 4 760 557
- IEEE JOURNAL OF SOLID-STATE CIRCUITS vol. 25, no. 1, February 1990, pages 55 - 60 , XP000101848 ISHIBASHI ET AL 'An alpha-immune, 2-V supply voltage SRAM using polysilicon PMOS load cell'

## Description

### BACKGROUND OF THE INVENTION

### 1. Field of the Invention

This invention relates to a semiconductor memory of the type called layer-built CMOS type SRAM.

### 2. Description of the Prior Art

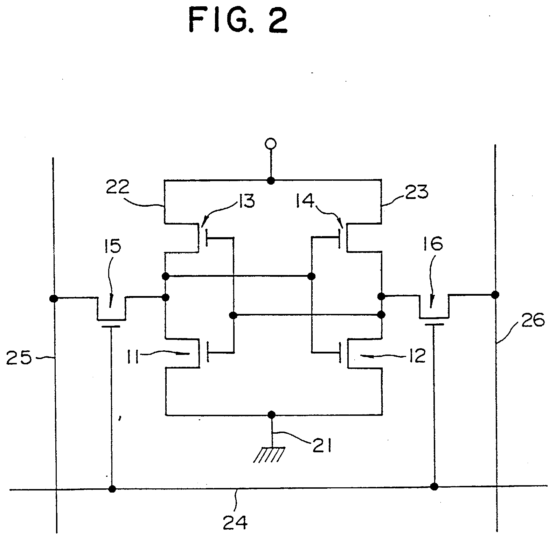

A complete CMOS type SRAM includes a large number of memory cells each of which has such a construction as shown Fig. 2. Referring to Fig. 2, the memory cell is composed of a flip-flop composed of a pair of N-channel MOS transistors 11 and 12 for driving and a pair of P-channel MOS transistors 13 and 14 for a load, and a pair of N-channel MOS transistors 15 and 16 for transfer.

A grounding line 21 is connected to source regions of the N-channel MOS transistors 11 and 13 while power source lines 22 and 23 are connected to source regions of the P-channel MOS transistors 13 and 14, respectively. Meanwhile, a word line 24 serves as gate electrodes of the N-channel MOS transistors 15 and 16, and bit lines 25 and 26 are connected to either ones of source/drain regions of the N-channel MOS transistors 15 and 16, respectively.

As a type of such complete CMOS type SRAM, there is a layer-built CMOS type SRAM wherein the P-channel MOS transistors 13 and 14 are each formed from a thin film transistor and the thin film transistors are layered on the N-channel MOS transistors 11 and 12.

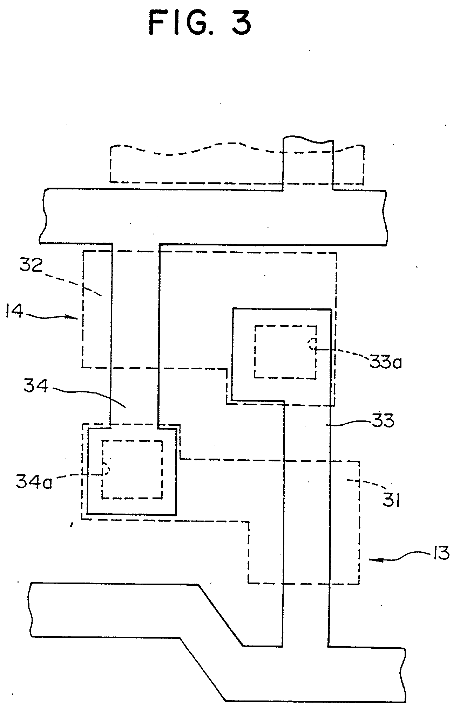

Fig. 3 shows such P-channel MOS transistors 13 and 14 in a layer-built CMOS type SRAM which is disclosed in Japanese Patent Application No. 1-91519 (JP-A-4 075 657) filed by the applicant of the present application.

In the layer-built CMOS type SRAM, gate electrodes of the P-channel MOS transistors 13 and 14 are formed from polycrystal Si films 31 and 32 in an upper layer on the N-channel MOS transistors 11 and 12, and active regions of and the power source lines 22 and 23 for the P-channel MOS transistors 13 and 14 are formed from polycrystal Si films 33 and 34 in a further upper layer.

Accordingly, an overlapping portion of the polycrystal Si film 33 with the polycrystal Si film 31 forms a channel region of the P-channel MOS transistor 13 while an overlapping portion of the polycrystal film 34 with the polycrystal Si film 32 forms a channel region of the P-channel MOS transistor 14.

It is to be noted that drain regions of the P-channel MOS transistors 13 and 14 of the polycrystal Si films 33 and 34 are connected to the polycrystal Si films 31 and 32 by way of contact holes 33a and 34a, respectively.

In the layer-built CMOS type SRAM described above, however, each of the channel regions of the P-channel MOS transistors 13 and 14 have a linear profile. Consequently, where the area of the memory cell is maintained. the channel length of the P-channel MOS transistors 13 and 14 cannot be made longer than the that of'the present memory cell.

Accordingly, with the layer-built CMOS type SRAM described above, it is difficult to decrease leak currents, that is, currents upon waiting, of the P-channel MOS transistors 13 and 14 to obtain a high data holding characteristic.

In US-A-4 760 557, a memory cell is disclosed which comprises two invertors, one of which has an increased output impedance and a larger output to input capacitance. This effect is achieved with enlarged channel regions of the transistors used for this invertor. To minimize the area of those channel regions and to achieve maximum shielding, the channel regions approximate concentric spirals and are bent and folded.

From the IEEE Journal of Solid-State Circuits, vol. 25, no. 1, February 1990, pages 55-60, Ishibashi et al.: "An α-Immune, 2-V Supply Voltage SRAM Using a Polysilicon PMOS Load Cell", it is known that a long channel of a load transistor of the invertors in a memory cell is effective in order to reduce the leakage current. This document also discloses that the channel length cannot be made larger without making the cell area of the memory cell larger.

### SUMMARY OF THE INVENTION

It is an object of the present invention to provide a semiconductor memory which is minimized in leak current and has a high data holding performance without an increased memory cell area.

In order to attain the object, according to the present invention, there is provided a semiconductor memory which comprises a memory cell including a pair of invertors which inputs and outputs are cross-coupled to each other, a pair of bit line connections and a pair of transmission transistors between the input/output terminal of said invertors and said pair of bit line connections, respectively, wherein each of said invertors has a load transistor employing a thin film as a channel region which is bent at an intermediate portion thereof.

With the semiconductor memory, since the channel region is bent at the intermediate portion thereof, the length of the channel region of the thin film transistor can be made longer with a same memory cell area comparing with an alternative case wherein such channel region has a linear profile. Consequently, a leak current, that is, a current upon waiting, can be decreased and a high data holding performance can be assured.

The above and other objects, features and advantages of the present invention will become apparent from the following description and the appended claims, taken in conjunction with the accompanying drawings in which like parts or elements are denoted by like reference characters.

### BRIEF DESCRIPTION OF THE DRAWINGS

Fig. 1 is a partial plan view of a semiconductor memory showing a preferred embodiment of the present invention:
Fig. 2 is a circuit diagram of an equivalent circuit of a complete CMOS type SRAM to which the present invention can be applied; and
Fig. 3 is a partial plan view of an exemplary one of conventional semiconductor memories.

### DETAILED DESCRIPTION OF THE PREFERRED EMBODIMENT

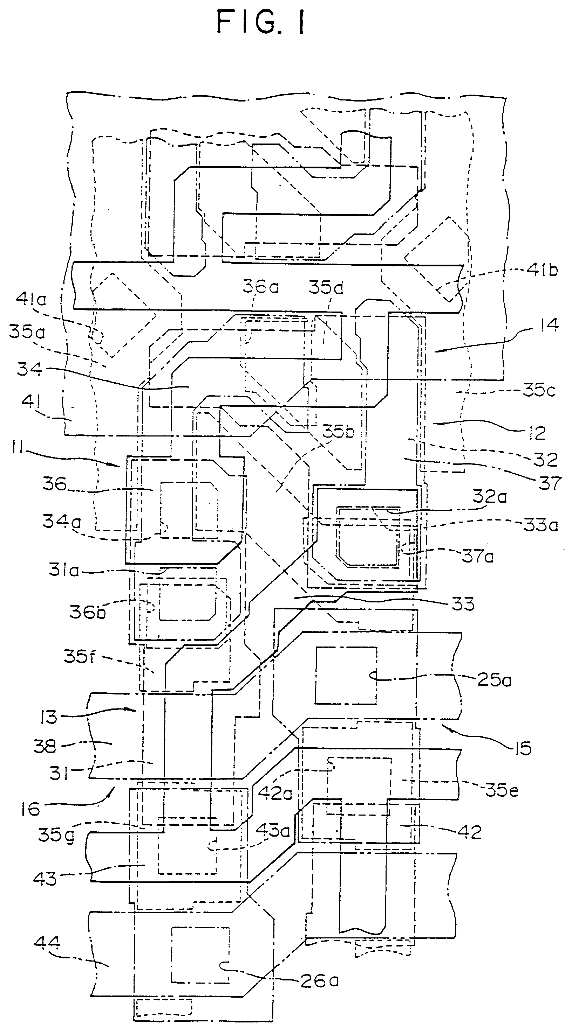

Referring to Fig. 1, there is shown a semiconductor memory to which the present invention is applied. The semiconductor memory is constructed as such a layer-built CMOS type SRAM as shown in Fig. 2. Thus, referring also to Fig. 2, the layer-built CMOS type SRAM includes a large number of memory cells. Each of such memory cells includes n+ diffused layers 35a to 35g formed in a Si substrate and making source/drain regions of N-channel MOS transistors 11, 12, 15 and 16. Gate electrodes, of of the N-channel MOS transistors 11 and 12 and a word line 24 are formed from polycrystal Si films 36 to 38 in a first layer on the Si substrate.

The polycrystal Si film 36 is held in flush contact with the n+ diffused layers 35d and 35f by way of contact holes 36a and 36b, respectively, while the polycrystal Si film 37 is held in flush contact with the n+ diffused layer 35b by way of a contact hole 37a.

A grounding line 21 is formed from a polycrystal Si film 41 in a second layer, and the polycrystal Si film 41 is connected to the n+ diffused layers 35a and 35c by way of contact holes 41a and 41b, respectively.

A polycrystal Si film 42 in the second layer same as the polycrystal Si film 41 extends from a location on the n+ diffused layer 35e to another location on the polycrystal Si film 38 while another polycrystal Si film 43 extends from a location on the n+ diffused layer 35g to another location on a polycrystal diffused layer 44 which is a word line for an adjacent memory cell.

The polycrystal Si films 42 and 43 are connected to the n+ diffused layers 35e and 35g by way of contact holes 42a and 43a, respectively.

Gate electrodes of P-channel MOS transistors 13 and 14 are formed from polycrystal Si films 31 and 32 in a third layer, and the polycrystal Si films 31 and 32 are connected to polycrystal Si films 36 and 37 by way of contact holes 31a and 32a, respectively.

Active regions of the P-channel MOS transistors 13 and 14 and power source lines 22 and 23 are formed from polycrystal Si films 33 and 34 in a fourth layer, and drain regions of the P-channel MOS transistors 13 and 14 of the polycrystal Si films 33 and 34 are connected to the polycrystal Si films 32 and 31 by way of contact holes 33a and 34a, respectively.

Accordingly, an overlapping portion of the polycrystal Si film 33 with the polycrystal Si film 31 forms a channel region of the P-channel MOS transistor 13 while an overlapping portion of the polycrystal Si film 34 with the polycrystal Si film 32 forms a channel region of the P-channel MOS transistor 14.

Bit lines 25 and 26 are formed from Al films (not shown) in an upper layer on the polycrystal Si films 33 and 34, and the Al films are connected to the polycrystal Si films 42 and 43 by way of contact holes 25a and 26a, respectively.

In the complete CMOS type SRAM of the present embodiment having such construction as described above, each of the channel regions of the P-channel MOS transistors 13 and 14 has a bent portion as apparently seen from Fig. 1. Consequently, even where the area of the memory cell is equal to that of the arrangement shown Fig. 3, the channel length of the P-channel MOS transistors 13 and 14 can be made longer than that of the arrangement of Fig. 3. Particularly, while the memory cell area in the present embodiment is 3.4 µm x 5.525 µm, the channel length of 2.3 µm can be assured.

Having now fully described the invention, it will be apparent to one of ordinary skill in the art that many changes and modifications can be made thereto without departing from the scope of the invention as defined by the appended claims.

## Claims

1. A semiconductor memory, comprising a memory cell including a pair of invertors (11,13 ; 12,14) which inputs and outputs are cross-coupled to each other, a pair of bit line connections (25,26) and a pair of transmission transistors (15,16) between the input/output terminals of said invertors (11,13 ; 12,14) and said pair of bit line connections (25,26), respectively, wherein each of said invertors (11,13 ; 12,14) has a load transistors (13,14) employing a thin film as a channel region, characterized in that said channel regions of said load transistors (13,14) are bent at an intermediate portion thereof.

2. A semiconductor memory according to claim 1, wherein said thin film transistors (13,14) are p-channel MOS transistors.

3. A semiconductor memory according to claim 1, wherein said channel regions are made of a fourth polycrystalline silicon film of a layered structure.

## Patentansprüche

1. Halbleiterspeicher, mit einer Speicherzelle, die ein Paar Inverter (11, 13; 12, 14), deren Eingänge und Ausgänge kreuzweise miteinander verbunden sind, ein Paar Bitleitungsverbindungen (25, 26) und ein Paar Übertragungstransistoren (15, 16) enthält, die sich jeweils zwischen den Eingangs-/Ausgangsanschlüssen der Inverter (11, 13; 12, 14) und dem Paar Bitleitungsverbindungen (25, 26) befinden, wobei jeder der Inverter (11, 13; 12, 14) einen Lasttransistor (13, 14) aufweist, der einen Dünnfilm als Kanalbereich verwendet, **dadurch gekennzeichnet**, daß die Kanalbereiche der Lasttransistoren (13, 14) in ihrem Mittelbereich gekrümmt sind.

2. Halbleiterspeicher nach Anspruch 1, **dadurch gekennzeichnet**, daß die Dünnfilmtransistoren (13, 14) p-Kanal MOS Transistoren sind.

3. Halbleiterspeicher nach Anspruch 1, **dadurch gekennzeichnet**, daß die Kanalbereiche aus einem vierten polykristallinen Siliziumfilm in einem geschichteten Aufbau hergestellt sind.

## Revendications

1. Mémoire à semi-conducteur, comprenant une cellule de mémoire qui comporte une paire d'inverseurs (11, 13 ; 12, 14) ayant des entrées et des sorties qui sont couplées mutuellement de manière croisée, une paire de connexions (25, 26) de ligne de bit et une paire de transistors (15, 16) de transmission placés entre les bornes d'entrée-sortie des inverseurs (11, 13 ; 12, 14) et la paire de connexions (25, 26) de ligne de bit respectivement, chacun des inverseurs (11, 13 ; 12, 14) ayant un transistor de charge (13, 14) comprenant un film mince comme région de canal, caractérisée en ce que la région de canal des transistors de charge (13, 14) est recourbée dans une partie intermédiaire.

2. Mémoire à semi-conducteur selon la revendication 1, dans laquelle les transistors (13, 14) à films minces sont des transistors MOS à canal p.

3. Mémoire à semi-conducteur selon la revendication 1, dans laquelle les régions de canal sont formées d'un quatrième film de silicium polycristallin ayant une structure à couches.
